# EUROPEAN PATENT SPECIFICATION

(11) **EP 0 454 054 B1**
(45) Date of publication and mention of the grant of the patent: **10.01.1996**
(21) Application number: 91106511.8
(22) Date of filing: 23.04.1991
(51) Int. Cl.: H01L 21/00

(54) **Lamp annealing apparatus and lamp annealing method**
Lampentempervorrichtung und Verfahren
Appareil de recuit par lampe et méthode

(30) Priority: 23.04.1990 JP 106916/90
(43) Date of publication of application: 30.10.1991
(73) Proprietor: SUMITOMO ELECTRIC INDUSTRIES, LTD., Osaka-shi, Osaka 541 (JP)
(72) Inventor: Shiga, Nobuo, c/o Yokohama Works, Sakae-ku, Yokohama-shi, Kanagawa (JP)
(74) Representative: Füchsle, Klaus, Dipl.-Ing.

(56) References cited:
- US-A- 4 221 956
- US-A- 4 830 700

## Description

### BACKGROUND OF THE INVENTION

### (Field of the Invention)

The present invention relates to lamp annealing apparatus and method, and more particularly to rapid annealing technology which is essential to manufacture a GaAs field effect transistor operating in a microwave range.

### (Related Background Art)

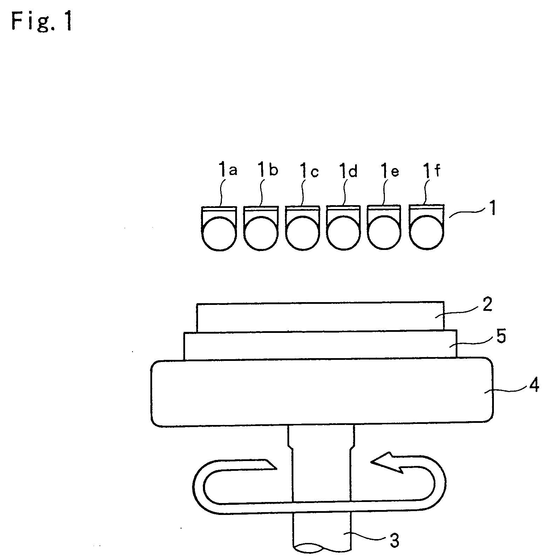

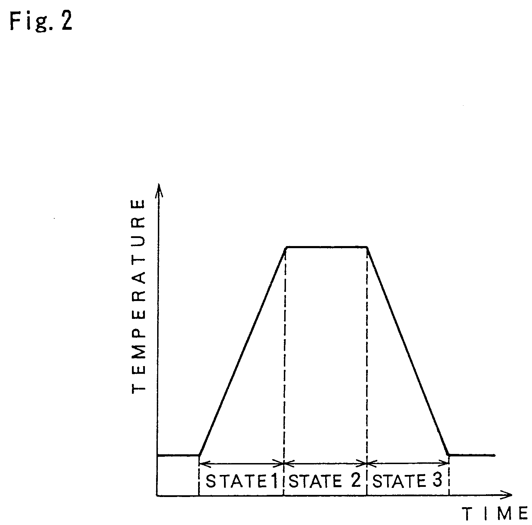

Fig.1 shows a conventional lamp annealing apparatus. In the rapid annealing by this apparatus, a temperature of a semiconductor wafer 2 is rapidly raised (heating step) by using lamps 1 such as infrared ray lamps as a heat source, maintaining it at the elevated temperature for a certain time period (steady state step), and temperature is rapidly dropped (cooling step). Fig.2 shows this process in which state 1 indicates the heating step, state 2 indicates the steady state step and state 3 indicates the cooling step.

Since the lamp effects annealing in a short time, the diffusion of injected ions and the evaporation of As on the semiconductor wafer can be prevented.

However, in the prior art lamp annealing, a slip line or a warp occurs in the semiconductor wafer probably due to a temperature difference between a center and a periphery of the semiconductor wafer during the rapid heating and the rapid cooling of the semiconductor wafer.

A further prior art that is of interest is US-A-4 649 261 that discloses an apparatus for heating semiconductor wafers in order to achieve annealing. It teaches the use of a mount on which is placed a semiconductor wafer that is to be annealed. Above the mount are heating lamps to heat the semiconductor wafer. Cooling gas blow means are arranged above the mount to cool said lamps, there being a sheet of quartz glass separating the semiconductor wafer from said blow means to ensure that the cooling gas cannot act on the semiconductor wafer.

### SUMMARY OF THE INVENTION

It is an object of the present invention to provide lamp annealing apparatus and method which does not cause a slip line of a warp in the semiconductor wafer.

The invention is as defined in the accompanying claims, the independent claims of which have been divided into a two part form based on the assumption that US-A-4 649 261 is the nearest state of the art.

The apparatus of the present invention comprises
a mount adapted to receive a semiconductor wafer thereon;
a heating lamp arranged in a vicinity of said mount to heat the semiconductor wafer to be mounted on said mount,
a cooling gas blow means arranged above said mount to blow cooling gas towards said semiconductor wafer;
said cooling gas blow means including a first blow path for blowing the cooling gas to the periphery of said semiconductor wafer and a second blow path for blowing the cooling gas toward the center of said semiconductor wafer, said first and said second blow path being mechanically distinct from each other.

The method of the present invention for lamp annealing a semiconductor wafer comprises a heat step, a steady state step and a cooling step, wherein
cooling gas is flown to the periphery of the semiconductor in said heating step by using a first blow path; and
cooling gas is flown toward the center of the semiconductor wafer in said steady step and said cooling step by using a second blow path that is mechanically distinct from said first blow path.

In order to analyze a cause of the slip line and the warp which occurred in the prior art, a relationship between a heating time of the semiconductor wafer and temperature rises at various portions of the semiconductor wafer was investigated. According to the analysis, a periphery of the semiconductor wafer is more easily heated than a center thereof in the heating step. and the periphery of the semiconductor wafer is more easily cooled than the center in the steady state step and the cooling step.

As seen from the above analysis, in the present apparatus and method, the periphery of the semiconductor wafer is cooled in the heating step of the annealing process and the center of the semiconductor wafer is cooled in the steady state step and the cooling step so that the center and the periphery of the semiconductor wafer are kept at uniform temperatures throughout the annealing process.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

Fig.1 shows a conventional heat radiation annealing apparatus,
Fig.2 shows a relationship between a heating time of a semiconductor wafer and temperature rises at various portions of the semiconductor wafer,
Fig.3 shows a heat radiation annealing apparatus in accordance with one embodiment of the present invention,
Fig.4 shows a perspective view of the embodiment of the present invention, and
Fig.5 shows a perspective view of a modification of the present invention.

### DETAILED DESCRIPTION OF THE PREFERRED EMBODIMENTS

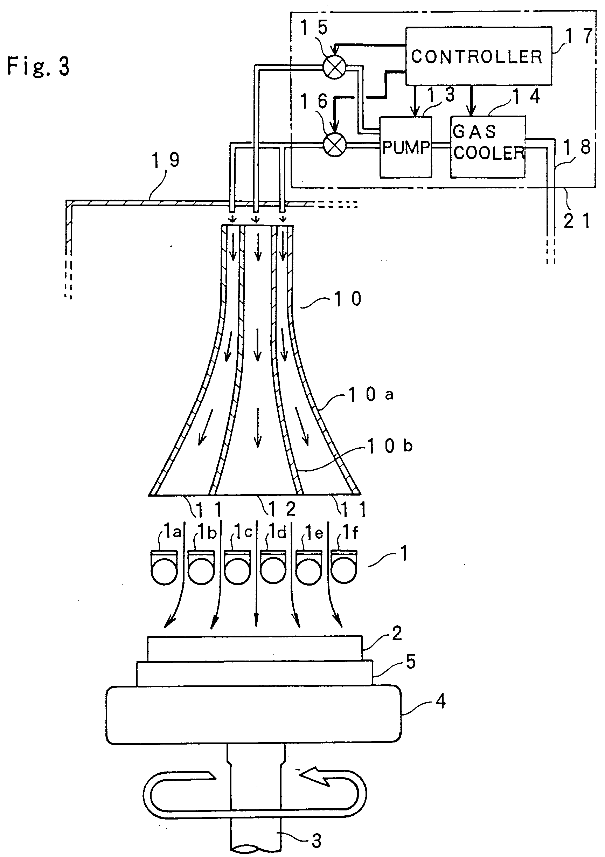

As shown in Fig.3, a semiconductor wafer 2 to be annealed is mounted on an auxiliary GaAs substrate 5 (which may be a Si substrate) arranged on a quartz suceptor 4 supported by a rotating shaft 3. A group of lamps 1 comprising tubular lamps 1a - 1f arranged in parallel are arranged above the semiconductor wafer 2, and cooling gas flow means 10 is arranged thereabove. Each of the lamps 1a - 1f is an infrared ray lamp having a tungsten filament longitudinally (normal to the plane of the drawing) arranged at the center of the tube. The cooling gas flow means 10 comprises an outer pipe 10a and an inner pipe 10b. The cooling gas flow means 10 is shown by a sectional view in Fig.3, and flows of the cooling gas therethrough are shown by arrows. All of those elements are arranged in a chamber 19 in a normal pressure N₂ environment. Cooling gas supply means 21 is provided externally of the chamber 19. The cooling gas supply means 21 comprises a pump 13, a gas cooling device 14, control valves 15 and 16, and a control unit 17.

The N₂ gas in the chamber 19 is supplied by the pump 13 to the cooling gas flow means 10 as cooling gas though the pipe 18, the gas cooling device 14, the pump 13 and the valve 15 or 16. The pump 13, the gas cooling device 14 and the valves 15 and 16 are controlled by the controller 17. For example, when the valve 15 is opened and the valve 16 is closed, the cooling gas is flown toward the center of the semiconductor wafer 2 through the inner pipe 10b. On the contrary, when the valve 16 is opened and the valve 15 is closed, the cooling gas is flown toward the periphery of the semiconductor wafer 2 through the outer pipe 10a. The temperature of the cooling gas is controlled by the gas cooling device 14 in accordance with a command from the controller 17.

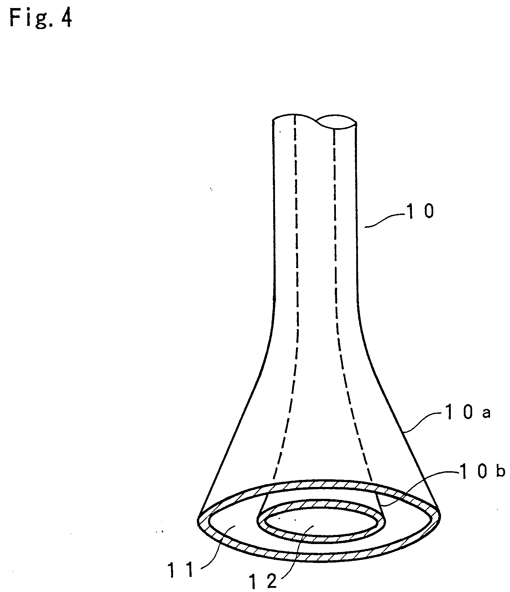

A construction of the cooling gas flow means 10 is shown in Fig.4. As shown, an outer opening 11 of the outer pipe 10b of the cooling gas flow means 10 spreads outward so that the cooling gas to the semiconductor wafer 2 is flown to a wide area. It is not always necessary to spread the openings but the openings may have the some width as other areas so long as the cooling gas is flown to a sufficiently wide area.

In the heating step in which the temperature of the semiconductor wafer 2 is raised from a room temperature to 950°C - 1000°C by the heat dissipation from the lamps 1, the N₂ gas which serves as the cooling gas is blown into the outer pipe 10a and it is discharged from the outer opening 11. As a result, the heat dissipation effect in the periphery of the semiconductor wafer 2 is enhanced so that the overall temperature distribution is kept uniform.

In the steady state step in which the temperature of the semiconductor wafer 2 is kept constant for 2 - 3 seconds, and in the cooling step in which the temperature of the semiconductor wafer 2 is rapidly dropped, the N₂ gas is flown into the inner pipe 10b and it is discharged from the inner opening 12. As a result, the heat dissipation effect at the center of the semiconductor wafer 2 is enhanced so that the overall temperature distribution is uniform. The heating step, the steady state step and the cooling step take approximately 10 seconds in total. In each step, the overall temperature distribution of the semiconductor wafer is uniform so that the slip line and the warp in the semiconductor wafer are prevented.

In the present embodiment, the heat is applied while the semiconductor wafer 2 is rotated so that the overall temperature distribution of the semiconductor wafer is further uniform.

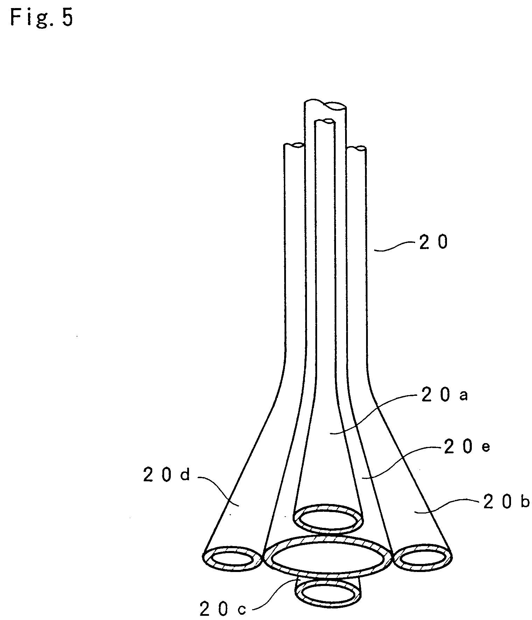

In a modification, cooling gas blow means 20 shown in Fig. 5 which comprises four outer pipes 20a, 20b, 20c and 20d and an inner pipe 20e may be used in place of the cooling gas flow means 10 to attain the same effect.

In the present embodiment, the tungsten lamps are used as the lamp 1 although other infrared ray lamps may be used. The shape of lamp may be spherical or ring.

In the present embodiment, the cooling gas is selectively blown to the center or the periphery of the semiconductor wafer, although it may be blown to both the center and the periphery of the semiconductor wafer with flow rate control.

The invention, and all such modifications as would be obvious to one skilled in the art are intended to be included within the scope of the following claims.

## Claims

1. A lamp annealing apparatus comprising:
a mount adapted to receive a semiconductor wafer (2) thereon;
a heating lamp (1) arranged in a vicinity of said mount to heat the semiconductor wafer (2) to be mounted on said mount;
said apparatus being characterized by
a cooling gas blow means (10) arranged above said mount to blow cooling gas towards said semiconductor wafer;
said cooling gas blow means (10) including a first blow path (10a) for blowing the cooling gas to the perpiphery of said semiconductor wafer and a second blow path (10b) for blowing the cooling gas toward the center of said semiconductor wafer, said first and said second blow path being mechanically distinct from each other.

2. A lamp annealing apparatus according to Claim 1, further comprising means (17) for controlling flow rates of the cooling gas blown through said first blow path (10b) and said second blow path (10a) of said cooling gas blow means (10).

3. A lamp annealing apparatus according to Claim 2, wherein said cooling gas flow rate control means (17) controls to flow the cooling gas selectively through said first blow path (10b) or through said second blow path (10a).

4. A lamp annealing method for a semiconductor wafer comprising a heat step, a steady state step and a cooling step, characterized in that;
cooling gas is flown to the periphery of the semiconductor in said heating step by using a first blow path (10a), and
cooling gas is flown toward the center of the semiconductor wafer in said steady step and said cooling step by using a second blow path (10b) being mechanically distinct from said first blow path (10a).

## Patentansprüche

1. Lampenglühvorrichtung, umfassend
- einen Träger, der eingerichtet ist, um einen Halbleiter-Wafer (2) darauf aufzunehmen,
- eine Heizlampe (1), die benachbart zum Träger angeordnet ist, um den auf dem Träger zu montierenden Halbleiter-Wafer (2) zu erhitzen,
wobei die Vorrichtung dadurch gekennzeichnet ist, daß
- eine Kühlgas-Gebläseeinrichtung (10) oberhalb des Trägers angeordnet ist, um Kühlgas zum Halbleiter-Wafer hinzublasen, und
- daß die Kühlgas-Gebläseeinrichtung (10) einen ersten Gebläseweg (10a) umfaßt, um das Kühlgas zum Rand des Halbleiter-Wafers zu blasen, und einen zweiten Gebläseweg (10b) umfaßt, um das Kühlgas zum Zentrum des Halbleiter-Wafers hinzublasen, wobei der erste und der zweite Gebläseweg mechanisch voneinander getrennt sind.

2. Lampenglühvorrichtung nach Anspruch 1, die ferner eine Einrichtung (17) zur Steuerung der Strömungsraten des Kühlgases, das durch den ersten Gebläsweg (10a) und den zweiten Gebläseweg (10b) der Kühlgas-Gebläseeinrichtung (10) geblasen wird, umfaßt.

3. Lampenglühvorrichtung nach Anspruch 2, wobei die Kühlgasströmungsraten-Steuereinrichtung (17) den Fluß des Kühlgases wahlweise durch den ersten Gebläseweg (10a) oder durch den zweiten Gebläseweg (10b) steuert.

4. Lampenglühverfahren für einen Halbleiter-Wafer, das einen Erhitzungsschritt, einen Schritt des stationären Zustandes und einen Abkühlschritt umfaßt, dadurch gekennzeichnet, daß
- Kühlgas beim Erhitzungsschritt unter Verwendung eines ersten Gebläseweges (10a) zum Rand des Halbleiters geleitet wird, und
- Kühlgas beim Schritt des stationären Zustandes und beim Abkühlschritt unter Verwendung eines zweiten Gebläseweges (10b), der mechanisch vom ersten Gebläseweg (10a) getrennt ist, zum Zentrum des Halbleiter-Wafers hin geleitet wird.

## Revendications

1. Dispositif de recuit à la lampe comprenant : un support conçu pour recevoir une tranche de semiconducteur (2) sur celui-ci,
une lampe de chauffage (1) disposée à proximité dudit support afin de chauffer la tranche de semiconducteur (2) devant être montée sur ledit support,
ledit dispositif étant caractérisé par
des moyens de soufflage (10) de gaz de refroidissement disposés au-dessus dudit support afin de souffler du gaz de refroidissement vers ladite tranche de semiconducteur,
lesdits moyens de soufflage (10) de gaz de refroidissement comprenant un premier trajet de soufflage (10a) destiné à souffler le gaz de refroidissement vers la périphérie de ladite tranche de semiconducteur et un second trajet de soufflage (10b) destiné à souffler le gaz de refroidissement vers le centre de ladite tranche de semiconducteur, lesdits premier et second trajets de soufflage étant mécaniquement distincts l'un de l'autre.

2. Dispositif de recuit à la lampe selon la revendication 1, comprenant en outre des moyens (17) pour commander le débit du gaz de refroidissement soufflé par l'intermédiaire dudit premier trajet de soufflage (10b) et dudit second trajet de soufflage (10a) desdits moyens de soufflage (10) de gaz de refroidissement.

3. Dispositif de recuit à la lampe selon la revendication 2, dans lequel lesdits moyens de commande du débit de gaz de refroidissement (17) agissent pour commander de façon sélective l'écoulement du gaz de refroidissement par l'intermédiaire dudit premier trajet de soufflage (10b) ou par l'intermédiaire dudit second trajet de soufflage (10a).

4. Procédé de recuit à la lampe d'une tranche de semiconducteur, comprenant une étape de chauffage, une étape d'état stable et une étape de refroidissement, caractérisé en ce que :
du gaz de refroidissement est soufflé à la périphérie de la tranche de semiconducteur au cours de ladite étape de chauffage en empruntant un premier trajet de soufflage (10a), et
du gaz de refroidissement est soufflé vers le centre de la tranche de semiconducteur au cours de ladite étape stable et de ladite étape de refroidissement en empruntant un second trajet de soufflage (10b) mécaniquement distinct dudit premier trajet de soufflage (10a).
